## Europäisches Patentamt

## European Patent Office

## Office européen des brevets

(19)

(11) Veröffentlichungsnummer: **0 057 256**
**B1**

(12) **EUROPÄISCHE PATENTSCHRIFT**

(45) Veröffentlichungstag der Patentschrift:
**22.05.85**

(51) Int. Cl.⁴: **H 01 L 29/78**

(21) Anmeldenummer: **81108295.7**

(22) Anmeldetag: **13.10.81**

(54) **Vertikal-MIS-Feldeffekttransistor mit kleinem Durchlasswiderstand.**

(30) Priorität: **02.02.81 DE 3103444**

(43) Veröffentlichungstag der Anmeldung:
**11.08.82 Patentblatt 82/32**

(45) Bekanntmachung des Hinweises auf die Patenterteilung:
**22.05.85 Patentblatt 85/21**

(84) Benannte Vertragsstaaten:
**CH DE FR GB IT LI SE**

(56) Entgegenhaltungen:
**US - A - 4 145 700**
**US - A - 4 209 795**

(73) Patentinhaber: **Siemens Aktiengesellschaft, Berlin und München Wittelsbacherplatz 2, D-8000 München 2 (DE)**

(72) Erfinder: **Tihanyi, Jenö, Dr., Wolfratshauser Strasse 179 b, D-8000 München 71 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung bezieht sich auf einen MIS-FET mit einem Halbleitersubstrat vom ersten Leitungstyp, mit mindestens einer in eine der Oberflächen des Substrats eingelassenen Kanalzone vom entgegengesetzten Leitungstyp und mit einer in die Kanalzone eingelassenen Sourcezone vom ersten Leitungstyp, mit einer an diese Oberfläche angrenzenden Drainzone und einer mit der anderen Oberfläche verbundenen Drainelektrode, mit mindestens einer Gateelektrode, die auf einer auf der einen Oberfläche angebrachten Isolierschicht sitzt, und mit einem Kontakt, der sowohl die Kanalzone wie auch die Sourcezone kontaktiert.

Ein solcher MIS-FET ist z.B. bereits in der DE-OS 2 703 877 beschrieben worden. Eine Ausführungsform ist als Vertikal-MIS-FET ausgeführt, bei dem die Sourceelektrode und die Drainelektrode auf verschiedenen Seiten des Halbleitersubstrats angeordnet sind. Bei solchen FET ist der Durchlasswiderstand im eingeschalteten Zustand um so höher, je höher die maximale Blockierspannung ist, für die der FET ausgelegt ist. Unter Blockierspannung wird dabei diejenige Sperrspannung verstanden, die der FET in Vorwärtsrichtung sperren kann. Der Durchlasswiderstand $R_{on}$ wächst dabei etwa proportional $U_{Block}^{2,5}$ an. Daraus ergibt sich, dass der Durchlasswiderstand $R_{on}$ für maximale Blockierspannungen oberhalb etwa 300 V grösser als bei für die gleiche Blockierspannung ausgelegten Bipolartransistoren ist.

Der Erfindung liegt die Aufgabe zugrunde, einen MIS-FET der oben genannten Art so weiterzubilden, dass der Durchlasswiderstand erheblich gesenkt werden kann.

Diese Aufgabe wird gelöst durch die Merkmale:

a) In die eine Oberfläche der Drainzone ist eine Injektorzone vom entgegengesetzten Leitungstyp eingelassen,
b) die Injektorelektrode der Injektorzone ist elektrisch mit der Gateelektrode verbunden,
c) die Gateelektrode überdeckt denjenigen Teil der Drainzone, der an der Oberfläche des Substrats und zwischen Kanalzone und Injektorzone liegt sowie die zwischen Sourcezone und dem genannten Teil der Drainzone liegende Kanalzone.

In der US-A-4 209 795 ist zwar bereits ein Feldeffekttransistor mit einer Injektorzone beschrieben worden. Hierbei handelt es sich jedoch nicht um einen MIS-FET, sondern um einen Junction-Feldeffekttransistor. Bei einem solchen Feldeffekttransistor wird die Leitfähigkeit des Kanals dadurch moduliert, dass Minoritätsladungsträger von einer Gatezone in den Kanal injiziert werden. Bei einem MIS-FET wird die Leitfähigkeit des Kanals jedoch ausschliesslich durch Feldeffekt gesteuert, wobei diese Steuerung im wesentlichen leistungslos und sehr schnell geschieht. Bei einem Junction-Feldeffekttransistor geschieht das Schalten jedoch wesentlich langsamer als bei einem MIS-FET, da bei ersterem Minoritätsladungsträger beteiligt sind, die beseitigt werden müssen, wenn der Transistor sperren soll. Diesen Nachteil weist der Anmeldungsgegenstand nicht auf.

Weiterbildungen der Erfindung sind Gegenstand der Unteransprüche.

Die Erfindung wird anhand einiger Ausführungsbeispiele anhand der Fig. 1 bis 4 näher erläutert. Es zeigen:

Fig. 1 einen Schnitt durch einen Vertikal-MIS-FET gemäss der Erfindung und

Fig. 2 bis 4 die Aufsicht auf drei Ausführungsbeispiele mit verschiedenen Formen von Sourcezonen und Injektorzonen.

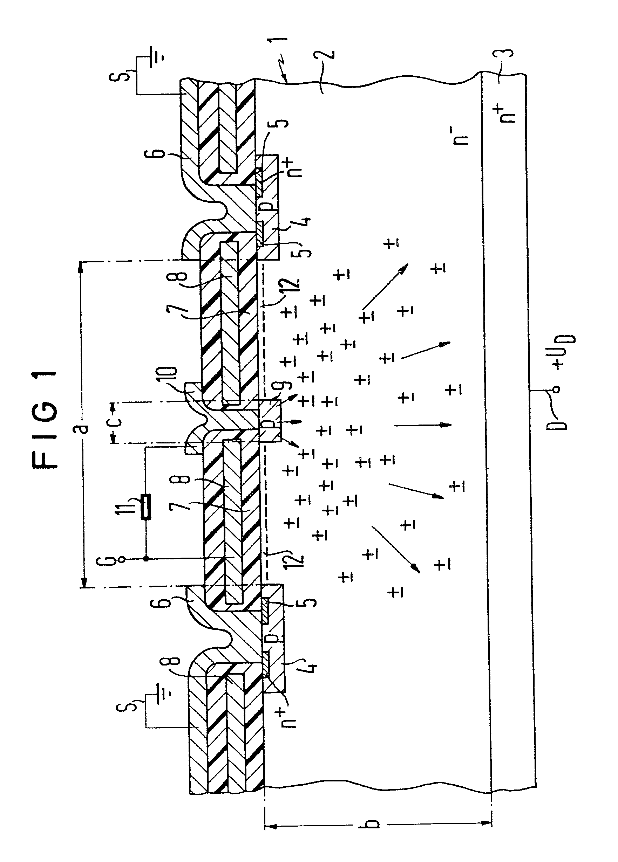

In Fig. 1 ist der Vertikal-MIS-FET mit 1 bezeichnet. Er hat ein beispielsweise schwach n-dotiertes Substrat 2, an das sich eine stark n-dotierte Zone 3 anschliesst. In die eine Oberfläche des Substrats 2 sind Kanalzonen 4 vom entgegengesetzten Leitungstyp eingelassen. Sie haben den Abstand a voneinander und sind in diesem Falle p-dotiert. In die Kanalzonen 4 sind Sourcezonen 5 vom ersten Leitungstyp eingelassen. Sie sind hier stark n-dotiert und können entweder durch Diffusion oder durch Ionenimplantation hergestellt sein. Im Substrat ist zwischen den Kanalzonen 4 eine Injektorzone 9 vom dem Substrat entgegengesetzten Leitungstyp und der Breite c angeordnet. Sie ist in diesem Fall p-dotiert und kann gleiche Tiefe und Dotierungskonzentration wie die Kanalzone 4 haben. Diejenige Oberfläche des Substrats 2, an der die Kanalzonen 4 und die Sourcezonen 5 sitzen, ist mit einer Isolierschicht 7 z.B. aus Siliciumdioxid bedeckt. Sie lässt lediglich Öffnungen frei, durch die die Kanalzonen 4, die Sourcezonen 5 und die Injektorzone 9 durch Kontakte 6 bzw. 10 kontaktiert sind. Auf der Isolierschicht 7 sitzt eine Gateelektrode 8, die die Kanalzonen 4 zwischen den Sourcezonen 5 und dem an die Oberfläche tretenden Teil des Substrats 2 überdeckt. Dieser und der darunterliegende Teil des Substrats 2 dient als Drainzone. An der anderen Oberfläche des Halbleiterkörpers ist eine Drainelektrode angebracht. Die Gateelektrode 8 ist mit einem Gateanschluss G versehen. Die Elektrode 10 der Injektorzone 9 ist an eine Spannung anlegbar, die eine Injektion von positiven Ladungsträgern in das Substrat 2 verursacht. Vorzugsweise kann die Elektrode 10 über einen Widerstand 11 mit dem Gateanschluss G verbunden sein.

Bei Anlegen einer positiven Gatespannung an die Gateelektrode G bildet sich an der Oberfläche der Kanalzone 4 zwischen den Sourcezonen 5 und dem Substrat 2 durch Feldeffekt ein n-leitender Kanal aus, durch den Elektronen von den Sourcezonen zur Drainzone fliessen. Durch die positive Aufladung der Gateelektrode 8 bildet sich an der Oberfläche des Substrats (d.h. in der Drainzone) eine stark n-leitende Akkumulationsschicht 12 aus. Diese hat angenähert ohmschen Charakter und hat daher gegenüber der Injektorzone 9 negatives Potential. Dadurch injiziert die Injektorzone 9 positive Ladungsträger in die Drainzone, die sich in einem bestimmten Bereich um die Injektorzone herum zur Drainelektrode D bewegen. Entsprechend der erhöhten Dichte von positiven Ladungsträgern findet auch eine Anreicherung von negativen Ladungsträgern im Bereich um und unter der Injektorzone 9 statt, was einer Erhöhung der Dotierungskonzentration im stromführenden Bereich gleichkommt. Dies heisst, dass der Durchlasswiderstand im eingeschalteten Zustand im stromführenden Bereich, der im wesentlichen unter der Akkumulationsschicht 12 und unter der Injektorzone 9 liegt, stark vermindert wird.

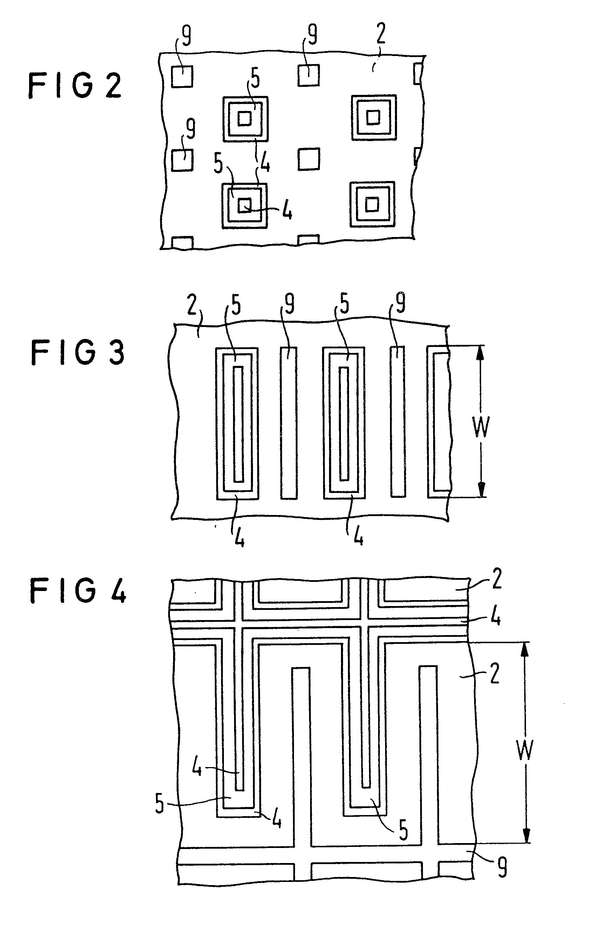

Um eine hohe Ladungsträgerdichte bei gleichzeitig geringem Injektorstrom zu ermöglichen, sollte die Breite der Injektorzone c klein gegen die Dicke b des Substrats sein. Bei einer Breite von c = 5 bis 10 μm und einer Dicke b = 50 μm und a = 50 μm wurde bei einem Injektorstrom von etwa 1 mA und einer Breite W von ca. 100 μm (siehe Fig. 3 und 4) eine Herabsetzung des Einschaltwiderstands $R_{on}$ um den Faktor 3 erzielt.

In den Fig. 2 bis 4 ist dargestellt, welche räumliche Zuordnung zwischen den Injektorzonen 9 und den Kanalzonen 4 und den Sourcezonen 5 getroffen werden kann. Der besseren Übersichtlichkeit halber sind in den genannten Figuren alle Kontakte, die Gateelektrode und die Isolierschicht entfernt. In Fig. 2 ist eine inselförmige Verteilung der Injektorzonen 9 gezeigt, bei der die genannten Zonen quadratisch ausgebildet sind. In Fig. 3 sind die Zonen streifenförmig ausgebildet und wechseln einander ab. In Fig. 4 sind die genannten Zonen als Kamm ausgebildet und miteinander verzahnt. In den Figuren sind jeweils Ausschnitte aus dem Substrat dargestellt; je nach der gewünschten Stromstärke ist eine Vervielfachung der gezeigten Anordnungen auf dem Substrat erforderlich. Die Kontakte werden dabei zweckmässigerweise durch metallische Leiterbahnen miteinander verbunden. Der in Fig. 1 gezeigte Widerstand 11 kann auch in das Substrat integriert werden. Es sind auch andere Formen möglich, wesentlich ist, dass die Injektorzone im stromführenden Bereich liegt.

Bei den gezeigten MIS-FET ist eine gewisse Ansteuerleistung notwendig. Der wesentliche Vorteil eines MIS-FET, nämlich die geringe Schaltzeit, bleibt jedoch erhalten. Im Gegensatz zu einem bipolaren Transistor werden hier nämlich die im Halbleiterkörper befindlichen Ladungsträger durch die Source-Drain-Spannung, also durch ein elektrisches Feld ausgeräumt und nicht durch Rekombination.

## Patentansprüche

1. MIS-FET mit einem Halbleitersubstrat vom ersten Leitungstyp, mit mindestens einer in eine der Oberflächen des Substrats (2) eingelassenen Kanalzone (4) vom entgegengesetzten Leitungstyp und mit einer in die Kanalzone eingelassenen Sourcezone (5) vom ersten Leitungstyp, mit einer an diese Oberfläche angrenzenden Drainzone (2) und einer mit der anderen Oberfläche verbundenen Drainelektrode (D), mit mindestens einer Gateelektrode (8), die auf einer auf der einen Oberfläche angebrachten Isolierschicht (7) sitzt, und mit einem Kontakt (6), der sowohl die Kanalzone (4) wie auch die Sourcezone (5) kontaktiert, gekennzeichnet durch die Merkmale:

a) In die eine Oberfläche der Drainzone (2) ist eine Injektorzone (9) vom entgegengesetzten Leitungstyp eingelassen,
b) die Injektorelektrode (10) der Injektorzone (9) ist elektrisch mit der Gateelektrode (8) verbunden,
c) die Gateelektrode (8) überdeckt denjenigen Teil der Drainzone (2), der an der Oberfläche des Substrats und zwischen Kanalzone (4) und Injektorzone (9) liegt sowie die zwischen Sourcezone (5) und dem genannten Teil der Drainzone (2) liegende Kanalzone (4).

2. MIS-FET nach Anspruch 1, dadurch gekennzeichnet, dass die Injektorzone (9) gleiche Tiefe und gleiche Dotierungskonzentration wie die Kanalzone (4) hat.

3. MIS-FET nach Anspruch 1 oder 2, dadurch gekennzeichnet, dass im Substrat mehrere Injektorzonen und mehrere Kanalzonen vorgesehen sind, dass die Injektorzonen und die Kanalzonen wenigstens annähernd gleichförmig über die Oberfläche des Substrats verteilt sind und dass die Kontakte der Injektorzonen elektrisch miteinander verbunden sind.

4. MIS-FET nach Anspruch 1 oder 2, dadurch gekennzeichnet, dass im Substrat abwechselnd streifenförmige Injektorzonen und streifenförmige Kanalzonen angeordnet sind und dass die Kontakte der Injektorzonen elektrisch miteinander verbunden sind.

5. MIS-FET nach Anspruch 1 oder 2, dadurch gekennzeichnet, dass die Injektorzone und die Kanalzone kammförmig ausgebildet ist und dass die Injektorzone mit der Kanalzone verzahnt ist.

6. MIS-FET nach einem der Ansprüche 1 bis 5, dadurch gekennzeichnet, dass die Injektorelektrode mit der Gateelektrode über einen Widerstand (11) verbunden ist.

## Claims

1. A MIS-FET comprising a semiconductor substrate of the first conductivity type, at least one channel zone (4) of the opposite conductivity type inserted into one of the surfaces of the substrate (2), a source zone (5) of the first conductivity type inserted into the channel zone, a drain zone (2) adjacent to this surface, a drain electrode (D) which is connected to the other surface, at least one gate electrode (8) which is arranged on an insulating layer disposed on the one surface, and a contact (6) which contacts both the channel zone (4) and the source zone (5), characterised by the features:

a) an injector zone (9) of the opposite conductivity type is inserted into the one surface of the drain zone (2),
b) the injector electrode (10) of the injector zone (9) is electrically connected to the gate electrode (8),
c) the gate electrode (8) covers both the part of the drain zone (2) which lies at the surface of the substrate between the channel zone (4) and the injector zone (9), and also the channel zone (4) which is arranged between the source zone (5) and said part of the drain zone (2).

2. A MIS-FET as claimed in Claim 1, characterised in that the injector zone (9) has the same depth and the same doping concentration as the channel zone (4).

3. A MIS-FET as claimed in Claim 1 or Claim 2, characterised in that a plurality of injector zones and channel zones are arranged in the substrate; that the injector zones and the channel zones are at least approximately evenly distributed over the surface of the substrate; and that the contacts of the injector zones are electrically connected to one another.

4. A MIS-FET as claimed in Claim 1 or Claim 2, characterised in that strip-shaped injector zones and strip-shaped channel zones are alternately arranged in the substrate; and that the contacts of the injector zones are electrically connected to one another.

5. A MIS-FET as claimed in Claim 1 or Claim 2, characterised in that the injector zone and the channel zone are comb-shaped; and that the injector zone is meshed with the channel zone.

6. A MIS-FET as claimed in one of Claims 1 to 5, characterised in that the injector electrode is connected to the gate electrode through a resistor (11).

**Revendications**

1. Transistor MIS-FET comportant un substrat semiconducteur possédant le premier type de conductivité, au moins une zone de canal (4) possédant le second type de conductivité et ménagée dans une première surface faisant partie des surfaces du substrat (2), et une zone de source (5) possédant le premier type de conductivité et ménagée dans la zone de canal, une zone de drain (2) jouxtant cette surface et une électrode de drain (D) reliée à l'autre surface, au moins une électrode de grille (8), qui est située sur une couche isolante (7) disposée sur la première surface, et un contact (6) qui contacte aussi bien la zone de canal (4) que la zone de source (5), caractérisé par les caractéristiques:

a) dans une surface de la zone de drain (2) se trouve ménagée une zone d'injection (9) possédant le type de conductivité opposé,
b) l'électrode d'injection (10) de la zone d'injection (9) est reliée électriquement à l'électrode de grille (8),
c) l'électrode de grille (8) recouvre la partie de la zone de drain (2), qui est située à la surface du substrat et entre la zone de canal (4) et la zone d'injection (9), ainsi que la zone de canal (4) située entre la zone de source (5) et la partie indiquée de la zone de drain (2).

2. Transistor MIS-FET suivant la revendication 1, caractérisé par le fait que la zone d'injection (9) possède la même profondeur et la même concentration de dopage que la zone de canal (4).

3. Transistor MIS-FET suivant la revendication 1 ou 2, caractérisé par le fait que plusieurs zones d'injection et plusieurs zones de canal sont prévues dans le substrat, que les zones d'injection et les zones de canal sont réparties au moins approximativement uniformément à la surface du substrat et que les contacts des zones d'injection sont reliés électriquement entre eux.

4. Transistor MIS-FET suivant la revendication 1 ou 2, caractérisé par le fait que des zones d'injection en forme de bandes et des zones de canal en forme de bandes sont disposées en alternance dans le substrat et que les contacts des zones d'injection sont reliés électriquement entre eux.

5. Transistor MIS-FET suivant la revendication 1 ou 2, caractérisé par le fait que la zone d'injection et la zone de canal sont réalisées en forme de peignes et que la zone d'injection et la zone de canal sont interdigitées.

6. Transistor MIS-FET suivant l'une des revendications 1 à 5, caractérisé par le fait que l'électrode d'injection est reliée à l'électrode de grille par l'intermédiaire d'une résistance (11).

FIG 1

FIG 2

FIG 3

FIG 4